# EUROPÄISCHE PATENTSCHRIFT

(11) **EP 3 804 223 B1**
(45) Veröffentlichungstag und Bekanntmachung des Hinweises auf die Patenterteilung: **08.01.2025**
(21) Anmeldenummer: 19727604.1
(22) Anmeldetag: 23.05.2019
(51) Int. Cl.: H04L 12/10, H04L 12/40, H04L 61/5038, H04L 12/403

(54) **VERFAHREN ZUR IDENTIFIZIERUNG VON BUSKNOTEN IN EINEM BUSSYSTEM**
METHOD FOR ADDRESS ALLOCATION IN A BUS SYSTEM
PROCÉDÉ DE DISTRIBUTION D'ADRESSE DANS UN SYSTÈME DE BUS

(30) Priorität: 05.06.2018 EP 18176099
(43) Veröffentlichungstag der Anmeldung: 14.04.2021
(73) Patentinhaber: Elmos Semiconductor SE, 44227 Dortmund (DE)
(72) Erfinder: SCHMITZ, Christian, 44575 Castrop-Rauxel (DE); BURCHARD, Bernd, 45276 Essen (DE)
(74) Vertreter: dompatent von Kreisler Selting Werner - Partnerschaft von Patent- und Rechtsanwälten mbB
(86) Internationale Anmeldenummer: PCT/EP2019/063333
(87) Internationale Veröffentlichungsnummer: WO 2019/233776

(56) Entgegenhaltungen:
- EP-B1- 1 490 772
- DE-A1- 102017 012 179
- ANONYMOUS: "LIN Bus Shunt Slave Node Position Detection - Revision 1.0", 10 December 2008 (2008-12-10), XP055529955, Retrieved from the Internet <URL:https://lin-cia.org/fileadmin/microsites/lin-cia.org/resources/documents/Bus_Shunt_Revision_1.pdf> [retrieved on 20181204]
- ANONYMOUS: "E521.36 - RGB LIN Controller with Current Source", 23 May 2017 (2017-05-23), XP055530720, Retrieved from the Internet <URL:https://www.elmos.com/fileadmin/elmos-website/products/interface/lin_transceiver_and_system_basis_chip/elmos-rgb-lin-controller-with-current-source-e52136-ds.pdf> [retrieved on 20181206]

## Beschreibung

Die Erfindung betrifft ein Verfahren zur Identifizierung von Busknoten in einem Bussystem. Insbesondere betrifft die Erfindung ein Verfahren zur Vergabe von Adressen in einem seriellen Datenbussystem, das eine Busleitung, einen Busmaster und mehrere Busslaves aufweist, wobei einerseits der Busmaster an die Busleitung angeschlossen ist und andererseits die Busslaves vom Busmaster aus betrachtet aufeinanderfolgend mit der Busleitung verbunden sind.

Es existiert eine Vielzahl von Verfahren zur automatischen Vergabe von Adressen in insbesondere seriellen Datenbussystemen (siehe z.B. EP-B-1 490 772, DE-A-10 2010 026 431, "LIN Bus Shunt Slave Node Position Detection - Revision 1.0", Kapitel 3.3, 10. Dezember 2008, E521.36 - RGB LIN Controller with Current Source", Kapitel 4.1.2, 23. Mai 2017).

Bei der automatischen Adressvergabe in Datenbussystemen ist in den Datenbus pro Busslave ein Busshunt geschaltet. Dieser Busshunt wird bei der Adressiervergabe verwendet. Danach ist er an sich nicht mehr erforderlich.

Um die Verluste in einem Datenbussystem, bei dem die automatische Adressvergabe abgeschlossen ist, weiter zu reduzieren, ist es wünschenswert, Busshunts einzusetzen, die nur einen relativ geringen ohmschen Widerstand aufweisen. Problematisch dabei allerdings ist, dass dann zur Erzielung ausreichend großer Messsignale der Adressierstrom, den die automatisch zu adressierenden Adressier-Busslaves in die Busleitung einspeisen, vergrößert werden muss. Damit wiederum besteht die Gefahr, dass die Maximalbusstrombelastung des Datenbussystems überschritten wird. Die Grenze, bis zu der ein Adressier-Busslave, der noch nicht adressiert ist, seinen in die Busleitung eingespeisten Adressierstrom erhöht, ist also gleich der Maximalbelastungsgrenze des Bussystems, ab der der Busmaster einen Fehlerfall diagnostizieren würde.

Problematisch ist der Fall des Mischverbaus von Adressier-Busslaves mit vergleichsweise großen Busshunts und Adressier-Busslaves mit kleineren Busshunts. Denn ein derartiger Mischverbau sollte unter dem Gesichtspunkt der Abwärtskompatibilität realisierbar sein, d.h. hinsichtlich der Möglichkeit gegeben sein, im Bedarfsfalle lediglich einige der Busslaves mit vergleichsweise großem Busshunt durch neuartige Busslaves mit kleinerem Busshunt zu ersetzen.

Aufgabe der Erfindung ist es, ein Verfahren zur Vergabe von Adressen in einem seriellen Datenbussystem anzugeben, bei dem herkömmliche adressierbare Busslaves zusammen mit neuartigen Busslaves, deren Busshunts kleiner sind, zusammen verwendet werden.

Zur Lösung dieser Aufgabe dient erfindungsgemäß ein Verfahren zur Identifizierung von Busslaves gemäß Anspruch 1.

Bei dem erfindungsgemäßen Verfahren wird, wie an sich bei einem seriellen LIN-Datenbussystem vorgesehen, pro Adressierzyklus zunächst ein Offset-Abgleich durchgeführt, bei dem jeder noch nicht adressierte Adressier-Busslave vom ersten Typ und jeder noch nicht adressierte Adressier-Busslave vom zweiten Typ mittels des ihm jeweils zugeordneten Strommessmittels einen potentiellen Ruhestrom misst. Anschließend wird, wie an sich ebenfalls bei einem seriellen LIN-Datenbussystem vorgesehen, in einer ersten (Preselect-)Phase eine Gruppe von noch nicht adressierten Adressier-Busslaves ausgewählt, um dann in der folgenden zweiten (Select-)Phase eines Adressierzyklus den vom Busmaster aus betrachtet am weitesten entfernt an den Bus angeschlossenen, noch nicht adressierten Adressier-Busslave zu identifizieren.

Nach der Erfindung weist das Datenbussystem zwei Typen von Adressier-Busslaves auf, nämlich Adressier-Busslaves vom alten ersten Typ (nachfolgend erste Adressier-Busslaves genannt) und Adressier-Busslaves vom neuen zweiten Typ (nachfolgend zweite Adressier-Busslaves genannt). Die beiden Typen von Adressier-Busslaves unterscheiden sich sowohl hinsichtlich ihrer Verschaltung mit der Busleitung als auch hinsichtlich der Größe des Adressierstroms. Jedem ersten Adressier-Busslave ist ein Strommessmittel (typischerweise in Form eines Busshunts) zugeordnet, dessen ohmscher Widerstand größer ist als derjenige der Strommessmittel der zweiten Adressier-Busslaves. Außerdem speist die Adressierstromquelle eines ersten Adressier-Busslaves den Adressierstrom, vom Busmaster aus betrachtet, vor dem diesem Adressier-Busslave zugeordneten Strommessmittel in die Busleitung ein. Während der Autoadressierphase erfasst also das Strommessmittel eines ersten Adressier-Busslaves den Busstrom ohne den "eigenen" Adressierstrom. Demgegenüber fließt der von einem zweiten Adressier-Busslave eingespeiste Adressierstrom durch das diesem zweiten Adressier-Busslave zugeordnete Strommessmittel.

Wenn also nun, wie es insbesondere bei seriellen LIN-Datenbussystemen vorgesehen ist, pro Adressierzyklus stets der am weitesten vom Busmaster entfernt an die Busleitung angeschlossene Adressier-Busslave identifiziert werden soll, um diesem Adressier-Busslave eine Adresse zuordnen zu können, so wird also ein insoweit "letzter" Adressier-Busslave vom ersten Typ dadurch identifiziert werden können, dass das diesem Adressier-Busslave zugeordnete Strommessmittel keinen Busstrom bzw., bei Berücksichtigung von minimalen Ruheströmen, die beispielsweise in einer der ersten Phase eines Adressierzyklus vorgeschalteten Offset-Abgleich detektiert werden könnten, keinen in der zweiten Phase gegenüber der ersten Phase veränderten Busstrom misst. Demgegenüber misst aber das Strommessmittel, das einem "letzten" an den Bus angeschlossenen zweiten Adressier-Busslave zugeordnet ist, einen Busstrom (nämlich seinen eigenen Adressierstrom). Es muss damit eine Strategie entwickelt werden, um einen letzten Adressier-Busslave vom zweiten Typ auf andere Weise als durch Untersuchung auf einen Busstrom von 0 Ampere zu erkennen. Dies gelingt erfindungsgemäß dadurch, dass untersucht wird, ob sich der von einem zweiten Adressier-Busslave eingespeiste Adressierstrom in der zweiten Phase eines Adressierzyklus gegenüber der ersten Phase verändert, nämlich verringert, oder ob der Adressierstrom in der zweiten Phase gleich dem Adressierstrom in der ersten Phase ist. Nur dann nämlich, wenn ein Adressier-Busslave vom zweiten Typ als letzter, d.h. vom Busmaster aus betrachtet am entferntesten an den Busslave angeschlossen ist, wird sich sein Adressierstrom in der zweiten Phase eines Adressierzyklus von demjenigen in der ersten Phase des Adressierzyklus nicht verändern. Denn erfindungsgemäß speist jeder zweite Adressier-Busslave einen solchen Adressierstrom in die Busleitung ein, dass das Strommessmittel dieses betreffenden zweiten Adressier-Busslave einen während der Adressenvergabe geltenden, vorgegebenen Maximalbusstrom misst. In Kombination mit dem Umstand, dass Adressier-Busslaves vom ersten Typ in der zweiten Phase eines Adressierzyklus einen größeren Adressierstrom einspeisen als in der ersten Phase, ergibt sich damit, wie nachfolgend beschrieben wird, die Möglichkeit der Identifikation eines Adressier-Busslaves vom zweiten Typ als "letzter" an den Bus angeschlossener Adressier-Busslave.

Die Identifikation als letzter zweiter Adressier-Busslave gelingt dadurch, dass sich der von diesem Adressier-Busslave eingespeiste Adressierstrom in der zweiten Phase nicht unterscheidet von demjenigen in der ersten Phase.

Befindet sich, vom Busmaster aus betrachtet, hinter einem zweiten Adressier-Busslave beispielsweise noch ein weiterer zweiter Adressier-Busslave, so speist dieser "vorletzte" zweite Adressier-Busslave weder in der ersten Phase noch in der zweiten Phase eines Adressierzyklus einen Adressierstrom ein. Denn der "hinter" dem betrachteten zweiten Adressier-Busslave befindliche zweite Adressier-Busslave speist ja bereits einen so gro-βen Adressierstrom ein, dass der Maximalbusstrom erreicht ist. Dadurch, dass der betrachtete vorletzte zweite Adressier-Busslave während des Adressierzyklus keinen Adressierstrom einspeist, scheidet er als Kandidat für den letzten an die Busleitung angeschlossenen Adressier-Busslave aus.

Befindet sich hinter einem zweiten Adressier-Busslave noch mindestens ein erster Adressier-Busslave, kann anhand einer Verringerung des Adressierstroms des zweiten Adressier-Busslaves in der zweiten Phase eines Adressierzyklus erkannt werden, dass dieser zweite Adressier-Busslave nicht der letzte und damit nicht der am weitesten vom Busmaster an die Busleitung angeschlossene Adressier-Busslave sein kann. Denn, wie oben erwähnt, speisen die ersten Adressier-Busslaves in der zweiten Phase eines Zyklus einen größeren Adressierstrom in die Busleitung ein als in der ersten Phase. Da nun die Adressierstromquelle eines zweiten Adressier-Busslave insoweit gesteuert ist, als sie automatisch einen Adressierstrom mit einem Wert einspeist, so dass das diesem zweiten Adressier-Busslave zugeordnete Strommessmittel weiterhin (nur) den Maximalbusstrom erfasst, wird die Adressierstromquelle dieses zweiten Adressier-Busslaves heruntergeregelt. Damit verringert sich also der Adressierbusstrom dieses zweiten Adressier-Busslaves in der zweiten Phase von demjenigen in der ersten Phase. Das ist das Kriterium dafür, um zu erkennen, dass der besagte zweite Adressier-Busslave nicht der letzte, d.h. nicht der am weitesten vom Busmaster entfernte, noch nicht adressierte Adressier-Busslave sein kann.

Nach dem erfindungsgemäßen Konzept ist es ferner möglich, dass das Datenbussystem zusätzlich auch Standard-Busslaves enthalten kann, die bereits eine feste Adresse aufweisen, also keine automatisch adressierbaren Busslaves sind. Derartige Standard-Busslaves können insbesondere auch während der Adressvergabe in die Busleitung zur Stabilisierung derselben Ruheströme einspeisen. Dies kann auch bei den ersten und zweiten Adressier-Busslaves der Fall sein. Wie bereits oben erwähnt, werden diese Ruheströme in einer der ersten Phase eines Adressierzyklus vorgeschalteten Offset-Abgleich messtechnisch erfasst und im weiteren Verlauf des Adressierzyklus bei der Einspeisung der Adressierströme der zweiten Adressier-Busslaves automatisch berücksichtigt, da sich diese Adressierströme danach richten, dass der Maximalbusstrom nicht überschritten wird.

Während der Adressvergabe speisen, wie oben im Einzelnen beschrieben, die Adressier-Busslaves ihre Adressierströme in die Busleitung ein. Anhand der Überschreitung eines vorgegebenen Maximalbusstroms wird in der Preselect-Phase, also in der ersten Phase eines Adressierzyklus, die Anzahl der an der Durchführung der zweiten Phase des Adressierzyklus teilnehmenden, noch nicht adressierten Adressier-Busslaves begrenzt. Im Rahmen dieser Vorauswahl reduzieren diejenigen Adressier-Busslaves, deren zugeordnete Strommessmittel einen Busstrom oberhalb des Maximalbusstroms erfassen, den Adressierstrom wieder. Diese Reduktion des Adressierbusstroms sollte schneller erfolgen als das vorherige Ansteigen der Adressierströme zuvor. Damit kann das Ausmaß, um das ein von einem Strommessmittel erfasster Busstrom den vorgegebenen Maximalwert überschreitet (Überschwingen), verringert werden. Der vorgegebene Maximalwert liegt unterhalb desjenigen Werts, bei dem der Busmaster auf Grund der Höhe des in ihm fließenden Stroms einen Kurzschluss und damit einen Fehlerfall detektieren würde. Grundsätzlich ist man bestrebt, den Maximalbusstrom bei der Adressvergabe nur möglichst wenig unterhalb des Werts für die Detektion eines Kurzschlusses in der Busleitung zu wählen. Je schneller also die einzelnen Adressierstromquellen derjenigen Adressier-Busslaves, deren zugeordnete Strommessmittel ein Überschreiten des Maximalbusstroms während der Adressvergabe detektieren, ihre Adressierströme herunterfahren, umso geringer kann die Differenz zwischen dem "Kurzschlussfall-Busstrom" und dem zulässigen Maximalbusstrom während der Adressvergabe sein. Diese zuvor genannten Gesichtspunkte sind aber im Übrigen bei den typischerweise bei seriellen Datenbussystemen zur Anwendung kommenden automatischen Adressvergabeverfahren zu berücksichtigen, weshalb die vorherigen Überlegungen dem Fachmann grundsätzlich geläufig sind.

In weiterer zweckmäßiger Ausgestaltung der Erfindung ist vorgesehen, dass die Strommessmittel der Adressier-Busslaves jeweils als ohmsche Widerstände realisiert sind, wobei der Wert des das Strommessmittel eines Adressier-Busslaves vom zweiten Typ repräsentierenden ohmschen Widerstands kleiner, insbesondere um mindestens das 5-Fache bis 20-Fache kleiner ist als der Wert des das Strommessmittel eines Adressier-Busslaves vom ersten Typ repräsentierenden ohmschen Widerstands. Die Shunt-Widerstände der Adressier-Busslaves vom zweiten Typ betragen beispielsweise 200 mΩ, während die Shunt-Widerstände der Adressier-Busslaves vom ersten Typ beispielsweise 1 Ω betragen. Die Unterschiede zwischen den Größen der Busshunts der Adressier-Busslaves der unterschiedlichen Typen beträgt also durchaus eine Zehnerpotenz oder aber auch mehr.

In weiterer zweckmäßiger Ausgestaltung der Erfindung kann vorgesehen sein, dass das Strommessmittel eines Adressier-Busslaves vom ersten Typ als in einem IC dieses Adressier-Busslaves integrierter Widerstand ausgebildet ist und dass das Strommessmittel eines Adressier-Busslaves vom zweiten Typ als Parallelschaltung aus einem in einem IC dieses Adressier-Busslaves integrierten Widerstand und einem außerhalb des IC angeordneten externen Widerstand ausgebildet ist, wobei die jeweils mit den integrierten Widerständen versehenen ICs der Adressier-Busslaves beider Typen gleich sind. Diese Weiterbildung der Erfindung hat den Vorteil, dass für die Adressier-Busslaves beider Typen die gleichen Autoadressier-ICs eingesetzt werden können. Diese ICs sind mit einem Busshunt versehen, der als integriertes Bauteil ausgeführt ist. Durch eine externe Anordnung eines zweiten Busshunts, der dann mit dem integrierten Busshunt in Parallelschaltung verschaltet ist, ergibt sich dann die Busshunt-Konstellation für einen Adressier-Busslave vom zweiten Typ. Damit kann für den Adressier-Busslave vom zweiten Typ auf die Autoadressier-ICs der Adressier-Busslave vom ersten Typ zurückgegriffen werden.

Wie bereits oben erwähnt, muss der Adressierstrom bei einem Adressier-Busslave vom zweiten Typ deutlich größer sein als derjenige eines Adressier-Busslave vom ersten Typ. Der zweite Adressierstrom kann bis zu dem 15-Fachen und mehr des ersten Adressierstrom betragen.

Wenn in einem seriellen Datenbussystem als Adressier-Busslaves ausschließlich Adressier-Busslaves vom zweiten Typ eingesetzt würden, so würde die Adressvergabe so ablaufen, wie es beispielsweise in EP-B-1 490 772, EP-A-2 571 200 oder EP-A-2 654 246 beschrieben ist.

Wenn im Zusammenhang mit Merkmalen der Erfindung vorstehend oder nachfolgend Werte oder Bereichsangaben mit "im Wesentlichen gleich" o.dgl. spezifiziert werden, so ist damit eine Abweichung von ± 50 % oder ± 25 % oder ± 10 % oder ± 5 % oder ± 2 % oder ± 0,5 % oder ± 0,1 % gemeint. Ein vorstehend oder nachfolgend angegebener Parameter, wie beispielsweise der von einem Strommessmittel eines Adressier-Busslaves gemessene Busstrom, der auf Gleichheit oder auf im Wesentlichen Gleichheit mit einem Vorgabewert untersucht wird, so ist mit "im Wesentlichen" ein Toleranzbereich gemeint, der alternativ die zuvor genannten Abweichungen vom zu vergleichenden Vorgabewert aufweist.

Die Erfindung wird nachfolgend unter Bezugnahme auf die Zeichnung näher erläutert. Im Einzelnen zeigen dabei:

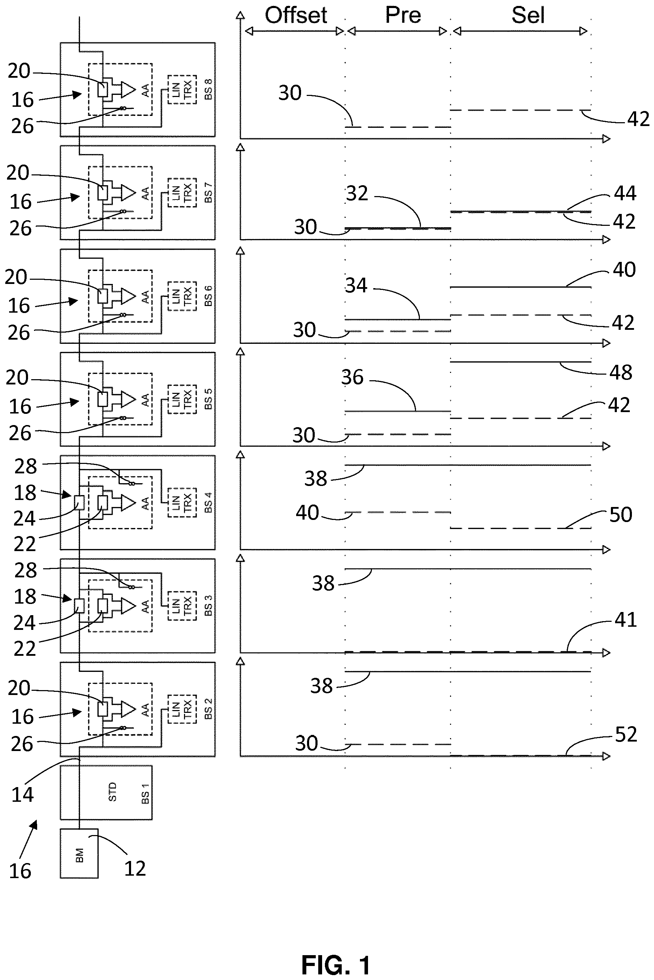

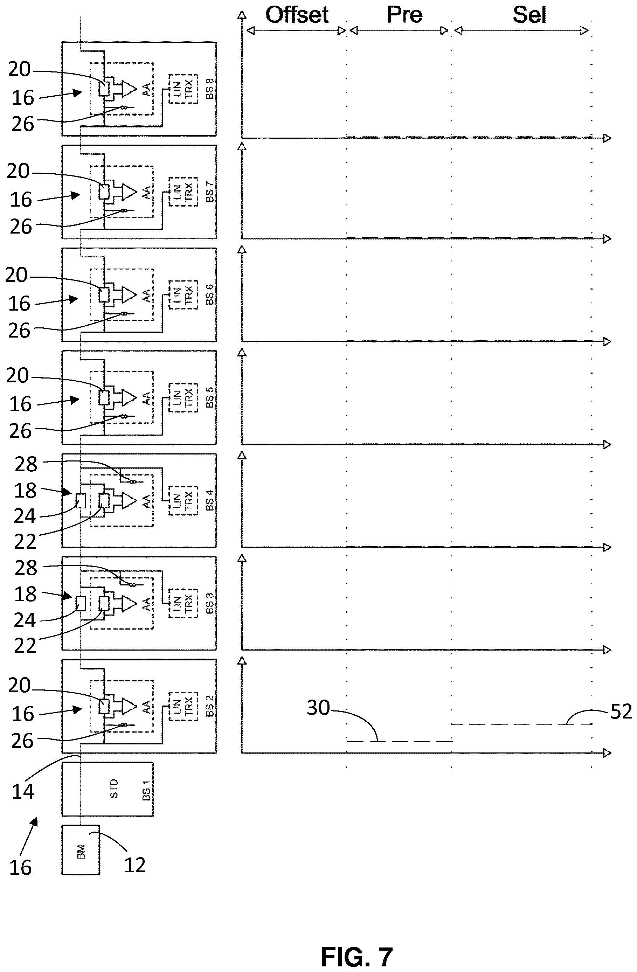

- Fign. 1 bis 7: jeweils links ein beispielhaftes serielles Datenbussystem mit einem Busmaster, einem Standard-Busslave mit fester Adresse, fünf Adressier-Busslaves vom ersten Typ, bei denen der Adressierstrom, vom Busmaster aus betrachtet, vor dem dem betreffenden Adressier-Busslave zugeordneten Strommessmittel in die Busleitung eingespeist wird, und zwei Adressier-Busslaves vom zweiten Typ, bei dem der Adressierstrom, vom Busmaster aus betrachtet, hinter dem betreffenden Strommessmittel in die Busleitung eingespeist wird, wobei in Höhe jedes Adressier-Busslaves der Verlauf und die Größe der in den einzelnen Adressierzyklen jeweils eingespeisten Adressierströme dargestellt ist,
- Fig. 8: ein erstes Ausführungsbeispiel der Beschaltung eines Adressier-Busslaves vom zweiten Typ (ohne Darstellung der Schaltung der Anwendung, die in dem Adressier-Busslave realisiert ist),
- Fig. 9: ein zweites Ausführungsbeispiel der Beschaltung eines Adressier-Busslaves vom zweiten Typ (ohne Darstellung der Schaltung der Anwendung, die in dem Adressier-Busslave realisiert ist),
- Fig. 10: ein drittes Ausführungsbeispiel der Beschaltung eines Adressier-Busslaves vom zweiten Typ (ohne Darstellung der Schaltung der Anwendung, die in dem Adressier-Busslave realisiert ist) und
- Fig. 11: ein viertes Ausführungsbeispiel der Beschaltung eines Adressier-Busslaves vom zweiten Typ (ohne Darstellung der Schaltung der Anwendung, die in dem Adressier-Busslave realisiert ist).

Anhand der Fign. 1 bis 7 wird nachfolgend beschrieben, wie sich die Einspeisung der Adressierströme während der aufeinanderfolgend ablaufenden Adressierzyklen unter dem Gesichtspunkt verändert, dass ein in einem Adressierzyklus identifizierter und somit adressierbarer Busslave an den nachfolgend ablaufenden Adressierzyklen nicht mehr beteiligt ist. Als Beispiel dient hier ein serielles Datenbussystem 10 mit einem Busmaster 12, von dem aus sich eine Busleitung 14 erstreckt. Seriell an die Busleitung 14 sind mehrere (im Ausführungsbeispiel acht) Busslaves verschiedener Typen angeschlossen, und zwar ein Standard-Busslave BS1, fünf Adressier-Busslaves BS2 und BS5 bis BS8 vom ersten Typ (nachfolgend erste Adressier-Busslaves genannt) und zwei Adressier-Busslaves BS3 und BS4 vom zweiten Typ (nachfolgend zweite Adressier-Busslaves genannt). In diesem Ausführungsbeispiel ist der Standard-Busslave BS1 der am nächsten zum Busmaster 12 angeordnete, an die Busleitung 14 angeschlossene Busslave. Vier der ersten Adressier-Busslaves, nämlich die Adressier-Busslaves BS5 bis BS8 sind am weitesten entfernt vom Busmaster 12 an die Busleitung 14 angeschlossen. Der noch verbleibende erste Adressier-Busslave BS2 folgt auf den Standard-Busslave BS1. Zwischen diesem ersten Adressier-Busslave BS2 und den vier anderen ersten Adressier-Busslaves BS5 bis BS8 sind an die Busleitung 14 die beiden zweiten Adressier-Busslaves BS3 und BS4 angeschlossen.

Wie anhand der Datenbusdarstellung in den Fign. 1 bis 7 gezeigt, ist jedem Adressier-Busslave BS2 bis BS8 jeweils ein Strommessmittel 16, 18 zugeordnet. Die ersten Adressier-Busslaves weisen dabei jeweils ein Strommessmittel 16 auf, das in diesem Ausführungsbeispiel als einzelner Busshunt 20 ausgeführt ist. Die zweiten Adressier-Busslaves BS3 und BS4 verfügen über jeweils ein Strommessmittel 18, das als Parallelschaltung aus zwei Busshunts 22, 24 ausgeführt ist. Hier ist es möglich, dass der Busshunt 22 jedes zweiten Adressier-Busslaves im Wesentlichen (siehe weiter oben die diesbezüglich angegebene Definition) gleich dem Busshunt 20 eines ersten Adressier-Busslaves ist. In jedem Fall ist der ohmsche Widerstand eines Strommessmittels 18 eines zweiten Adressier-Busslaves deutlich kleiner als der Widerstand des Strommessmittels 16 eines ersten Adressier-Busslaves.

Jeder der Adressier-Busslaves BS2 bis BS8 verfügt über eine eigene Adressierstromquelle 26 bzw. 28. Die Adressierstromquellen 26 der ersten Adressier-Busslaves BS2 und BS5 bis BS8 speisen Strom, vom Busmaster 12 aus betrachtet, vor dem dem jeweiligen ersten Adressier-Busslave zugeordneten Strommessmittel 16 ein. Demgegenüber wird von den Adressierstromquellen 28 der zweiten Adressier-Busslaves BS3 und BS4 Strom an einer Stelle in die Busleitung 14 eingespeist, die sich, vom Busmaster 12 aus betrachtet, hinter dem jeweils zugeordneten Strommessmittel 18 befindet.

Während der Adressvergabe speisen die zuvor beschriebenen Adressierstromquellen Strom in die Busleitung 14 ein. Dieser Strom fließt zum Busmaster 12. Unter Berücksichtigung der Stromrichtung sind die Adressier-Busslaves BS2 bis BS7 stromab des Adressier-Busslaves BS8 an die Busleitung 14 angeschlossen. Der erste Adressier-Busslave BS8 ist der vom Busmaster 12 aus betrachtet am von diesem weitesten entfernt an die Busleitung 14 angeschlossene Adressier-Busslave. Die Adressier-Busslaves BS3 bis BS8 sind stromauf des zum Busmaster 12 nächstgelegenen, an die Busleitung 14 angeschlossenen ersten Adressier-Busslave BS2 an die Busleitung 14 angeordnet.

Ausgangspunkt für die nachfolgend beschriebene Adressvergabe ist die Situation, in der noch keiner der sieben adressierbaren Adressier-Busslaves BS2 bis BS8 mit einer Adresse versehen bzw. für eine Adressierung vorbereitet sind.

Im ersten Adressierzyklus (siehe Fig. 1) wird in einer Offset-Abgleich zunächst ermittelt, welchen Strom die einzelnen Strommessmittel 16, 18 messen, ohne dass die Adressierstromquellen 26, 28 Adressierstrom in die Busleitung 14 einspeisen. In der graphischen Verlaufsdarstellung der während eines Adressierzyklus von einem Strommessmittel gemessenen Stroms (siehe die jeweils rechten Darstellungen in den Fign. 1 bis 7) ist hier ein (Ruhe-)Strom von Null visualisiert. Im Regelfall wird in der Offset-Abgleich aber ein Reststrom gemessen, der dann bei der späteren Auswertung Berücksichtigung findet.

Aus Gründen der Vereinfachung der Beschreibung des erfindungsgemäßen Verfahrens wird im vorliegenden Fall davon ausgegangen, dass dieser Reststrom Null beträgt.

In der ersten Phase Pre des ersten Adressierzyklus speisen die vier am weitesten vom Busmaster 12 aus betrachtet an die Busleitung 14 angeschlossenen ersten Adressier-Busslaves BS5 bis BS8 einen vergleichsweise geringen vorgegebenen Preselect-Adressierstrom 30 in die Busleitung 14 ein. Der am weitesten vom Busmaster 12 angeordnete erste Adressier-Busslave BS8 erfasst diesen Strom 30 (d.h. seinen eigenen Preselect-Adressierstrom) nicht. Der stromab des letzten ersten Adressier-Busslaves BS8 angeordnete erste Adressier-Busslave BS7 misst den Busstrom 32 und speist selbst den Preselect-Adressierstrom 30 ein. Entsprechend erfasst nun der nächste stromab an die Busleitung 14 angeschlossene erste Adressier-Busslave BS6 einen Busstrom 34, der der Summe der Preselect-Adressierströme entspricht, die die beiden ersten Adressier-Busslaves BS7 und BS8 eingespeist haben. Er selbst speist wiederum den Preselect-Adressierstrom 30 ein. Der erste Adressier-Busslave BS5 misst nun als Busstrom das 3-Fache des Preselect-Adressierstroms, also den Busstrom 36 und speist wiederum selbst den Preselect-Adressierstrom 30 ein.

Die Adressier-Stromeinspeisung in den beiden zweiten Adressier-Busslaves BS3 und BS4 weicht von dem zuvor beschriebenen Konzept ab. Bei diesen beiden Adressier-Busslaves BS3 und BS4 wird die jeweilige Adressierstromquelle 28 derart angesteuert, dass der von dem Strommessmittel 18 gemessene Busstrom 38 den Wert Iₛₒₗₗ annimmt. Dazu speist der stromab auf den ersten Adressier-Busslave BS5 folgende zweite Adressier-Busslave BS4 einen Adressierstrom 40 ein, der in Summe mit dem von dem ersten Adressier-Busslave BS5 kommenden Busstrom 36 den Busstrom 38 ergibt, der gleich Iₛₒₗₗ ist.

Der benachbart zum zweiten Adressier-Busslave BS4 angeordnete weitere zweite Adressier-Busslave BS3 empfängt also den Busstrom 38, der gleich dem Wert Iₛₒₗₗ ist, so dass seine Adressierstromquelle 28 einen Adressierstrom 41 von Null in die Busleitung 14 einspeist.

Der am nächsten zum Busmaster 12 angeordnete erste Adressier-Busslave BS2 misst an seinem Strommessmittel 16 wiederum den Busstrom 38 und speist selbst seinen Preselect-Adressierstrom 30 in die Busleitung 14 ein.

In der sich an die erste Phase Pre anschließenden zweiten Phase Sei des ersten Adressierzyklus erhöht nun jeder der vier ersten Adressier-Busslaves BS5 bis BS8 seinen Adressierstrom, so dass jeder dieser Adressier-Busslaves den Select-Adressierstrom 42 in die Busleitung 14 einspeist. Das Konzept der Detektion des Busstroms in Höhe der jeweiligen Adressier-Busslaves ist, bezogen auf die vier ersten Adressier-Busslaves BS5 bis BS8 ähnlich dem, was zuvor für die erste Phase Pre beschrieben ist. Der erste Adressier-Busslave BS8 speist seinen Select-Adressierstrom ein. Der benachbarte erste Adressier-Busslave BS7 misst diesen Adressierstrom als Busstrom 44 und speist selbst den Select-Adressierstrom 42 ein. Der nächste erste Adressier-Busslave BS6 misst dann den Busstrom 46 als das Doppelte des von den beiden vorherigen ersten Adressier-Busslaves eingespeisten Select-Adressierstroms 46 und speist selbst wiederum den Select-Adressierstrom 42 ein.

Somit misst also der in Richtung auf den Busmaster 12 betrachtet nächste erste Adressier-Busslave BS5 den Busstrom 48 und speist selbst wiederum den Select-Adressierstrom 42 ein.

Die Situation ändert sich nun im Hinblick auf den folgenden zweiten Adressier-Busslave BS4. Dieser zweite Adressier-Busslave BS4 steuert seine Adressierstromquelle 28 dergestalt, dass der von ihm erfasste Busstrom 38 den Wert Iₛₒₗₗ annimmt. Damit dies auch bei einem im Vergleich zur ersten Phase Pre nunmehr vom ersten Adressier-Busslave BS5 kommenden Busstrom weiterhin gewährleistet ist, muss der zweite Adressier-Busslave BS4 seine Adressierstromquelle 28 herunterregeln, und zwar vom Preselect-Adressierstrom 40 zum Select-Adressierstrom 50. Der nächste zweite Adressier-Busslave BS3 verhält sich weiterhin "neutral". Seine Adressierstromquelle 28 ist deaktiviert und speist weiterhin den Adressierstrom 41 von Null in die Busleitung 14 ein.

Im noch verbleibenden ersten Adressier-Busslave BS2 ist bereits während der ersten Phase Pre des Adresszyklus erkannt worden, dass der Busstrom 38 oberhalb der für die Preselect-Phase vorgegebenen Stromgrenze liegt. Damit hat dieser erste Adressier-Busslave BS2 erkannt, dass er über die erste Phase hinaus nicht an der zweiten Phase Sei des ersten Adressierzyklus teilnimmt. Sein Select-Adressierstrom 52 ist also Null.

Nach Abschluss der zweiten Phase Sei des ersten Adresszyklus kann nun auf Grund der folgenden Gegebenheiten der vom Busmaster 12 aus betrachtet am weitesten von diesem entfernt an die Busleitung 14 angeschlossene erste Adressier-Busslave BS8 als "letzter" der noch nicht adressierten Adressier-Busslaves beider Typen identifiziert werden. Dies gelingt, indem dieser erste Adressier-Busslave BS8 der einzige Adressier-Busslave vom ersten Typ ist, dessen vom Strommessmittel 16 gemessener Busstrom gegenüber der Offset-Messung unverändert geblieben ist. Damit "weiß" dieser letzte erste Adressier-Busslave BS8, dass vom Busmaster 12 aus betrachtet hinter ihm kein noch nicht adressierter Adressier-Busslave vorhanden ist.

Innerhalb der beiden zweiten Adressier-Busslaves BS3 und BS4 erfolgt die Entscheidung, ob einer von ihnen der insoweit letzte noch nicht adressierte Adressier-Busslave ist, auf andere Weise. Der zweite Adressier-Busslave BS4 erkennt, dass sich sein Adressierstrom zwischen der ersten Phase Pre und der zweiten Phase Sei verringert hat. Dies kann nur darin begründet sein, dass diesem zweiten Adressier-Busslave BS4 seitens stromauf angeordneter, noch nicht adressierter Adressier-Busslaves Strom zugeführt worden ist. Damit kann dieser besagte zweite Adressier-Busslave BS4 nicht der "letzte" noch nicht adressierte Adressier-Busslave sein.

Im Falle des weiteren zweiten Adressier-Busslave BS3 erfolgt die Entscheidung, dass es sich nicht um den "letzten" noch nicht adressierten Adressier-Busslave handeln kann, anhand der Tatsache, dass dieser zweite Adressier-Busslave bereits in der ersten Phase Pre des Adresszyklus keinen Adressierstrom in die Busleitung 14 eingespeist hat. Das bedeutet, dass, vom Busmaster 12 aus betrachtet, hinter diesem zweiten Adressier-Busslave BS3 bereits mindestens ein Adressier-Busslave vom zweiten Typ vorhanden sein muss, der noch nicht adressiert ist.

Auf die zuvor beschriebene Weise kann also am Ende der zweiten Phase Sei des ersten Adresszyklus der erste Adressier-Busslave BS8 als "letzter" an die Busleitung 14 angeschlossener noch nicht adressierter Adressier-Busslave identifiziert werden. Diesem Busslave kann nun direkt im Anschluss an den ersten Adressierzyklus eine Adresse zugeordnet werden.

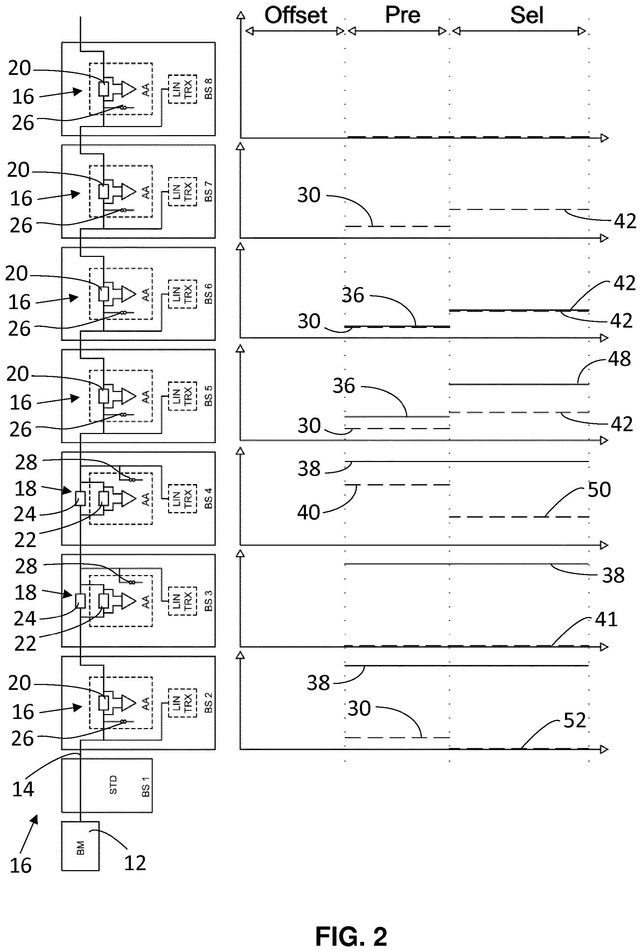

Der zeitliche Verlauf der Adressstromeinspeisung in dem zweiten Adresszyklus ist in Fig. 2 gezeigt. Der zuvor identifizierte und damit adressierbare oder bereits adressierte letzte Adressier-Busslave BS8 nimmt nun nicht mehr teil. Dies wird in Fig. 2 dadurch symbolisiert, dass dieser Adressier-Busslave BS8 keinen Adressierstrom einspeist.

Die Adressierstromverläufe der am Verfahren noch teilnehmenden Adressier-Busslaves BS2 bis BS7 sind in Fig. 2 gezeigt. Es stellen sich ähnliche Verhältnisse ein, wie im ersten Adressierzyklus anhand von Fig. 1 beschrieben. Für die Größe der Adressierströme, die die einzelnen Adressier-Busslaves BS2 bis BS7 einspeisen, und die Größe der Busströme, die die einzelnen Adressier-Busslaves messen, gilt das zuvor Gesagte entsprechend. Nach Abschluss der zweiten Phase Sei des zweiten Adressierzyklus kann auf Grund der gleichen Umstände, wie sie zuvor anhand von Fig. 1 beschrieben worden sind, entschieden werden, dass es sich bei dem Adressier-Busslave BS7 um denjenigen noch nicht adressierten Adressier-Busslave handeln muss, der der letzte und damit vom Busmaster 12 aus betrachtet am weitesten entfernt an die Busleitung angeschlossene Adressier-Busslave ist. Wiederum gilt für den Adressier-Busslave BS4 vom zweiten Typ, dass sein Adressierstrom in der zweiten Phase Sei gegenüber der ersten Phase Pre verringert ist (siehe den Übergang zwischen dem Busstrom 40 in der ersten Phase Pre und dem Busstrom 50 in der zweiten Phase Sei des zweiten Adressierzyklus). Der weitere zweite Adressier-Busslave BS3 speist bereits in der ersten Phase Pre gar keinen Adressierstrom ein. Damit ist klar, dass der nach dem zweiten Adresszyklus adressierbare Adressier-Busslave der Adressier-Busslave BS7 ist.

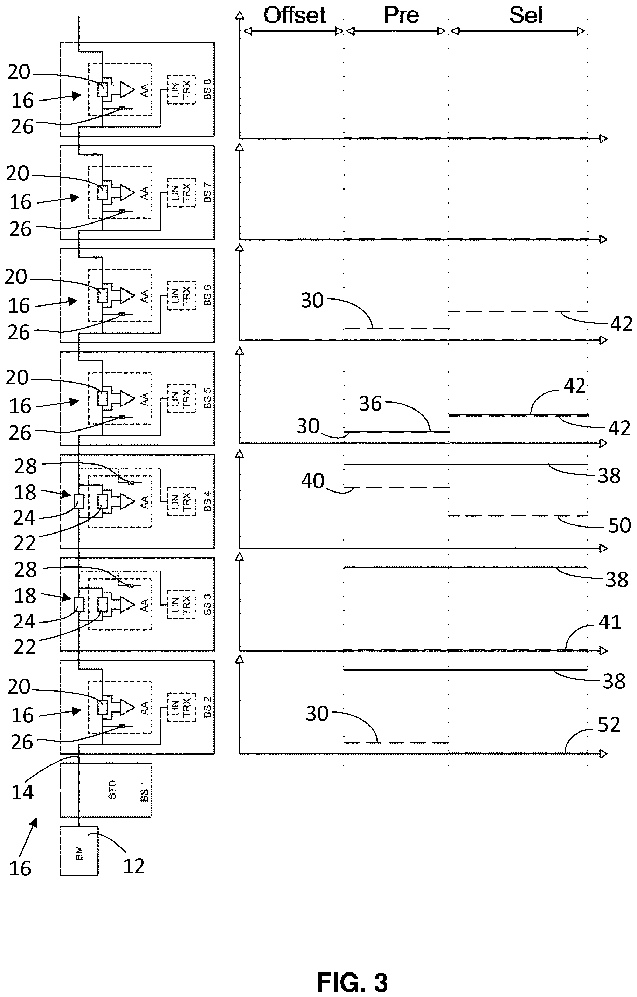

Fig. 3 zeigt die Adressierstromverläufe der noch nicht adressierten Adressier-Busslaves BS2 bis BS6 in dem dritten Adressierzyklus. Die Randbedingungen für die Größen der von den einzelnen noch nicht adressierten Adressier-Busslaves BS2 bis BS6 eingespeisten Adressierströme und gemessenen Busströme sind entsprechend der zuvor beschriebenen Beschreibung der beiden vorherigen Adressierzyklen. Am Ende des Adressierzyklus gemäß Fig. 3 ergibt sich also aus den gleichen Überlegungen, wie bereits oben ausgeführt, dass der erste Adressier-Busslave BS6 der am weitesten vom Busmaster 12 an die Busleitung angeschlossene, noch nicht adressierte Adressier-Busslave ist, so dass diesem Adressier-Busslave BS6 nun eine Adresse zugeordnet werden kann.

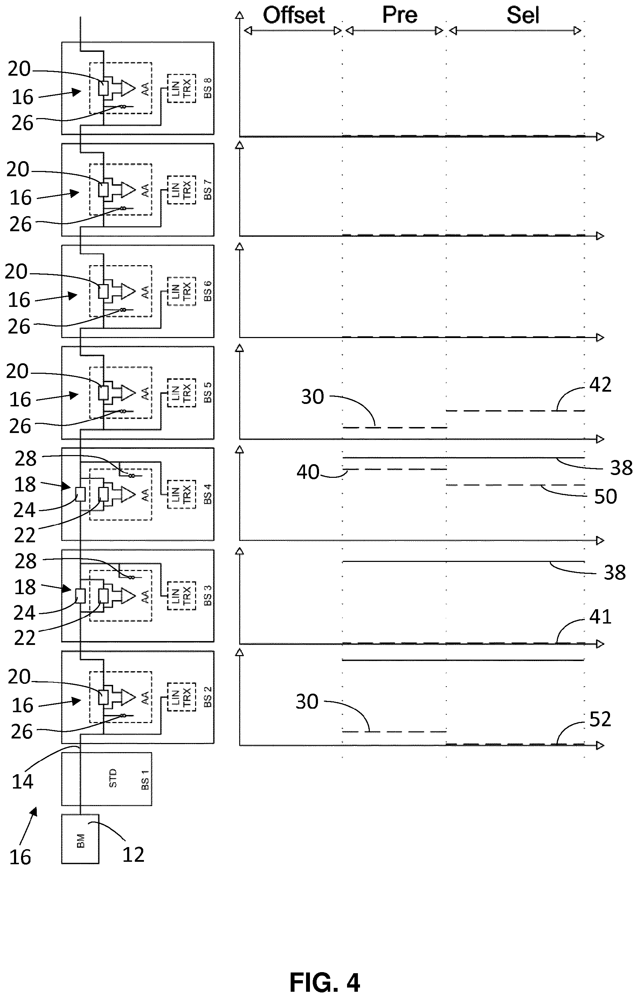

Im vierten Adressierzyklus gemäß Fig. 4 stellt sich dann heraus, dass der erste Adressier-Busslave BS5 der im vorherigen Sinne letzte noch nicht adressierte Adressier-Busslave ist, so dass diesem nun eine Adresse zugewiesen werden kann.

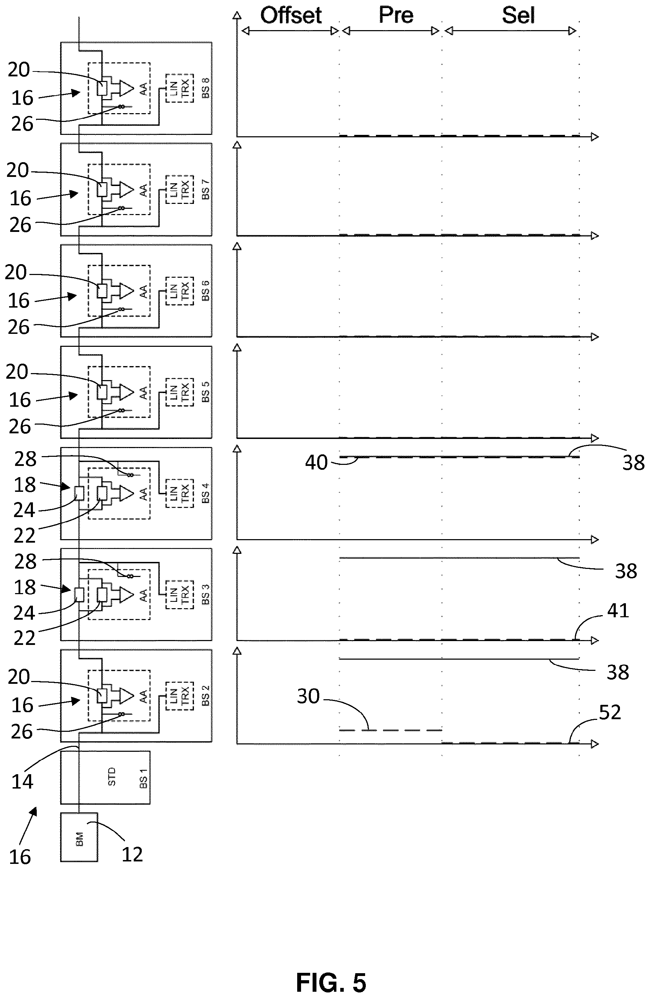

Eine hinsichtlich der Selektion des "letzten" Adressier-Busslave veränderte Situation ergibt sich im fünften Adressierzyklus gemäß Fig. 5. Die vier am Ende und damit am weitesten entfernt vom Busmaster 12 an die Busleitung 14 angeschlossenen ersten Adressier-Busslaves BS5 bis BS8 nehmen sämtlich nicht mehr am Adressvergabeverfahren teil. Somit ist nun der Adressier-Busslave BS4 vom zweiten Typ der "letzte" noch nicht adressierte Adressier-Busslave. Dies wird erkannt anhand des Umstands, dass dieser Adressier-Busslave BS4 in der ersten Phase Pre des Adressierzyklus einen Adressierstrom ungleich Null in die Busleitung 14 einspeist und dass sich dieser Adressierstrom in der zweiten Phase Sel des Adressierzyklus nicht verändert. Demgegenüber speist der stromab dieses besagten Adressier-Busslaves BS4 angeschlossene zweite Adressier-Busslave BS3 in der ersten Phase Pre keinen Adressierstrom ein und demzufolge auch in der zweiten Phase Sei des Adressierzyklus keinen Adressierstrom ein. Der letzte noch verbliebene, noch nicht adressierte Adressier-Busslave BS2 vom ersten Typ "merkt" wiederum bereits in der ersten Phase Pre des Adressierzyklus, dass der Grenzwert für den während dieser Phase zulässigen Busstrom überschritten ist (nämlich durch die Steuerung der Adressierstromquelle 28 des zweiten Adressier-Busslave BS4), weshalb er in der zweiten Phase Sei dieses Adressierzyklus nicht mehr an der Adressvergabe teilnimmt.

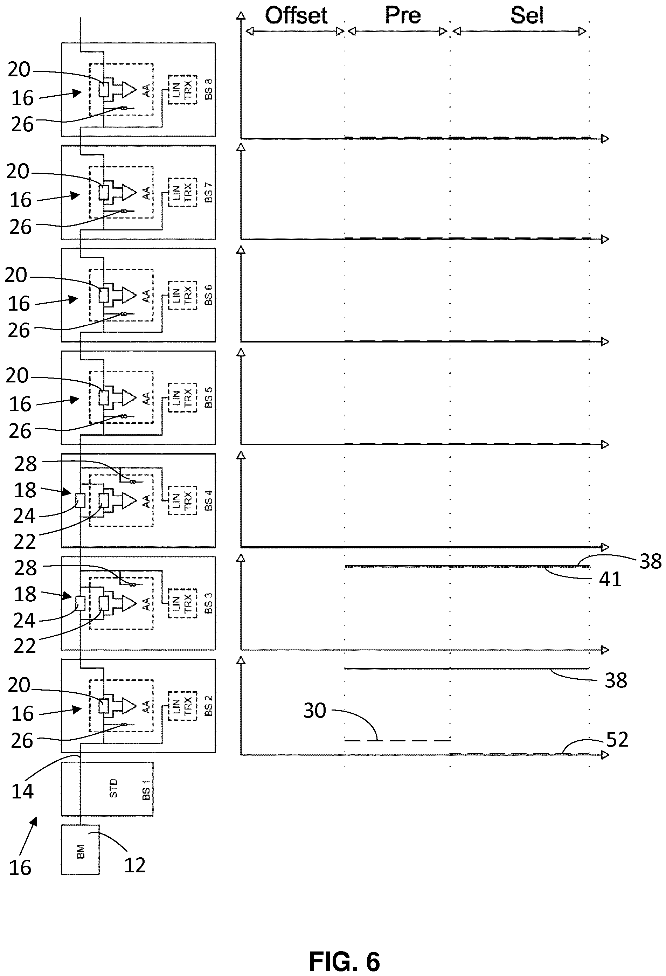

Auf entsprechende Weise kann dann im sechsten Adressierzyklus gemäß Fig. 6 nach Abschluss der zweiten Phase Sel erkannt werden, dass nun der Adressier-Busslave BS3 vom zweiten Typ der letzte noch nicht adressierte Adressier-Busslave ist, so dass diesem nun eine Adresse zugeordnet werden kann.

Schließlich ergibt sich im nächsten (siebten) Adressierzyklus, dass nun der noch nicht adressierte erste Adressier-Busslave BS2 derjenige ist, dem eine Adresse zugeordnet werden kann.

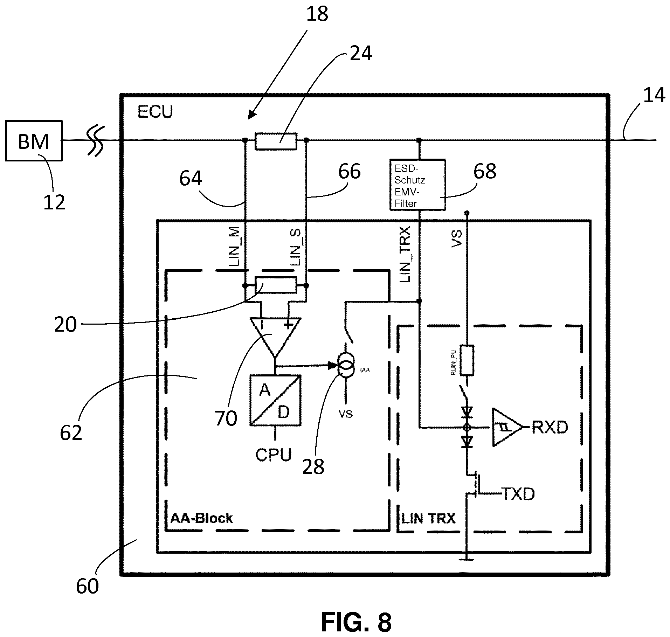

Wie bereits oben beschrieben, unterscheiden sich die beiden Typen von Adressier-Busslaves einerseits durch den Ort der Adressierstromeinspeisung in die Busleitung und andererseits durch die Größe ihrer Busshunts bzw. ihrer Strommessmittel. In Fig. 8 ist ein erstes Ausführungsbeispiel eines Adressier-Busslaves 60 vom zweiten Typ gezeigt. Die Adressierstromquelle 28 ist, vom Busmaster 12 aus betrachtet, hinter dem Strommessmittel 18 des Adressier-Busslaves 60 vom zweiten Typ angeordnet. Sie speist also den Adressierstrom an einer Stelle in die Busleitung 14 ein, so dass das Strommessmittel 18 die Summe aus bereits über die Busleitung 14 geliefertem Busstrom und Adressierstrom erfasst.

Die Besonderheit besteht nun darin, dass unter Verwendung der gleichen Autoadressier-ICs 62, wie sie auch für Adressier-Busslaves vom ersten Typ eingesetzt werden, ein Adressier-Busslave 60 vom zweiten Typ aufgebaut werden kann. Das besagte Autoadressier-IC 62 weist den integrierten Busshunt 20 auf. Zwischen die beiden beidseitig dieses Busshunts 20 aus dem IC herausgeführten und mit der Busleitung 14 verbundenen Anschlussleitungen 64, 66 ist nun der zweite Busshunt 24 geschaltet. Damit ergibt sich als wirksamer Busshunt die Parallelschaltung aus den beiden Busshunts 20 und 24, so dass per Definition dieser sich ergebende Busshunt, also das Strommessmittel 18, einen geringeren ohmschen Widerstand aufweist als die Busshunts 20, also die Strommessmittel 16 der Adressier-Busslaves vom ersten Typ.

Im Ausführungsbeispiel gemäß Fig. 8 wird der Adressierstrom über eine kombinierte EMV-Schutz- und Filterschaltung 68 in die Busleitung 14 eingespeist. Durch einen Messverstärker 70 wird der Spannungsabfall über der Parallelschaltung aus den Busshunts 20 und 24, also über dem effektiven Busshunt erfasst, und das Ausgangssignal des Messverstärkers 70 wird gegebenenfalls nach einer Signalverarbeitung zur Steuerung der Adressierstromquelle 28 genutzt, so dass sich in Höhe des Anschlusses des Busslave 60 vom zweiten Typ in der Busleitung 14 der Strom Iₛₒₗₗ einstellt. Über die Schutz- und Filterschaltung 68 erfolgt im Übrigen nach Adressvergabe und damit während des normalen Bussystembetriebs die Kommunikation über die Busleitung 14 mit dem Busslave.

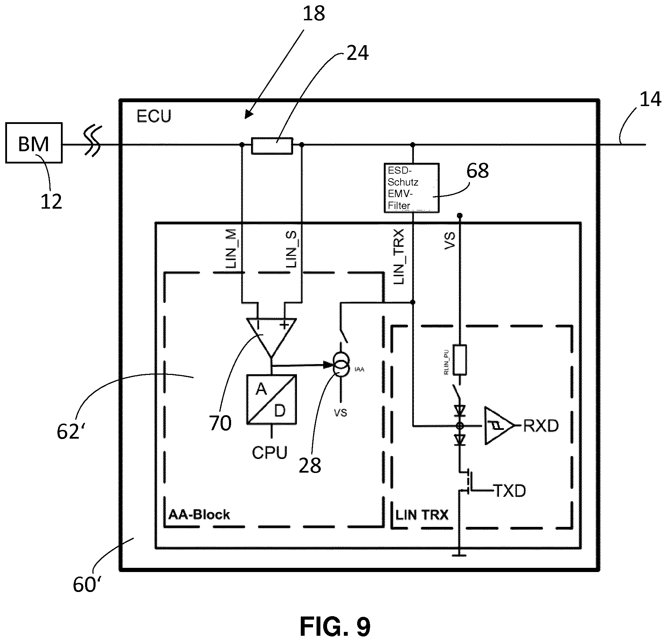

In Fig. 9 ist ein alternatives Ausführungsbeispiel eines Adressier-Busslaves 60' vom zweiten Typ gezeigt. Im Unterschied zum Ausführungsbeispiel nach Fig. 8 wird hier auf den integrierten Busshunt 20 verzichtet. Das Strommessmittel 18 umfasst also als einzigen Busshunt den Busshunt 24, der, wie auch im Ausführungsbeispiel nach Fig. 8, in die Busleitung 14 geschaltet ist.

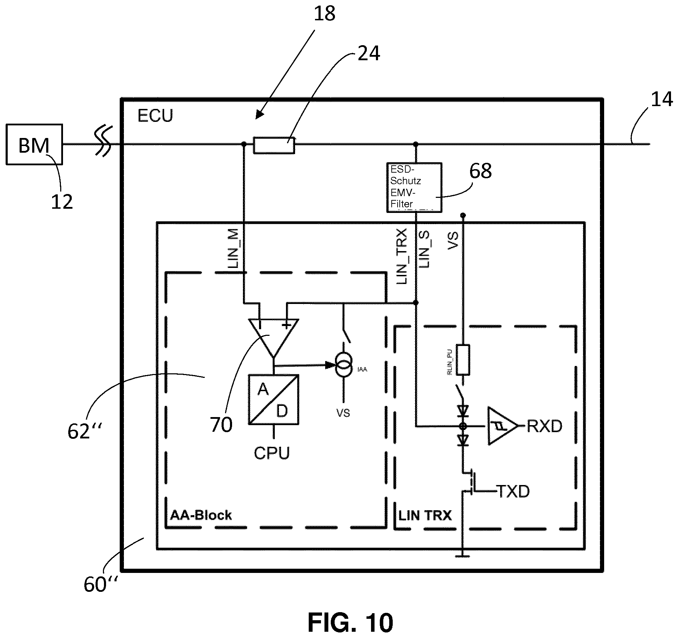

Fig. 10 zeigt eine weitere Variante eines Adressier-Busslaves 60" vom zweiten Typ. In diesem Ausführungsbeispiel sind aus dem Adressier-IC 62" lediglich zwei Leitungen herausgeführt, wobei der in Höhe des Adressier-Busslaves 60" fließende Busstrom als Spannungsabfall über dem einzigen vorhandenen Busshunt 24 und der kombinierten EMV-Schutz- und Filterschaltung 68 gemessen wird.

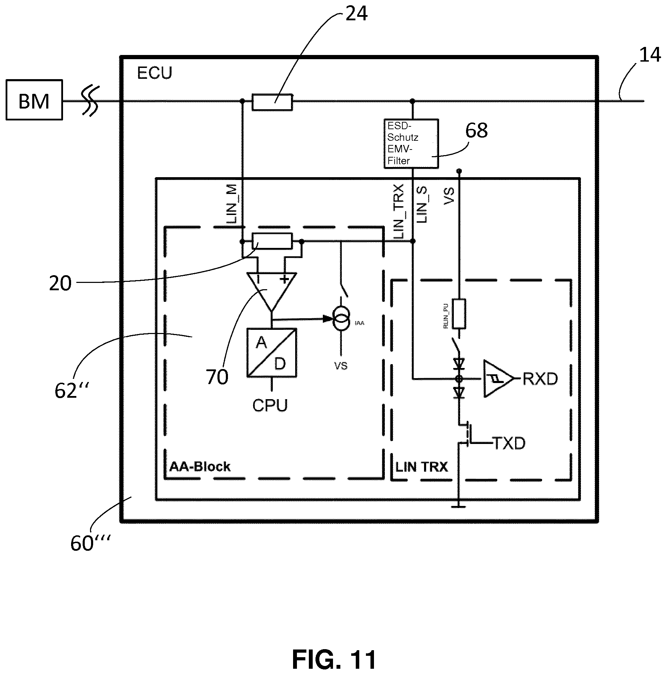

Schließlich zeigt Fig. 11 ein viertes Ausführungsbeispiel eines Adressier-Busslave 60"' vom zweiten Typ. Das Autoadressier-IC 62" weist wiederum den integrierten Busshunt 20 auf. Wie im Ausführungsbeispiel gemäß Fig. 10 wird der in Höhe des Adressier-Busslave 60"' fließende Busstrom als Spannungsabfall über der Parallelschaltung aus dem integrierten Busshunt 20 und der Reihenschaltung aus dem Busshunt 24 und der kombinierten Schutz- und Filterschaltung 68 gemessen.

Hinsichtlich der Messmethode zur möglichst verfälschungsfreien Erfassung des während der Adressvergabe jeweils in Höhe der adressierten Busslaves in der Busleitung 14 fließenden Ströme sei auf die DE-A-10 2018 104 489 verwiesen.

Anders ausgedrückt kann der erfindungswesentliche Aspekt wie folgt beschrieben werden.

Zu Beginn eines Frames, den der Busmaster beim Autoadressieren auf den Bus legt, sind Zeitintervalle eingeplant für den Offset-Abgleich, die Preselect-Phase (erste Phase) und die Select-Phase (zweite Phase). Nach weiteren Daten, die dann übertragen werden, folgt die in diesem Adressierzyklus zu vergebende Adresse.

Beim Offset-Abgleich misst jeder Adressier-Busslave den über sein Strommessmittel fließenden Ruhestrom.

In der Preselect-Phase (erste Phase) speisen die Adressier-Busslaves vom ersten Typ einen gewissen voreingestellten Strom (Preselect-Strom) sein. Da sich die Strommessmittel bei den Adressier-Busslaves vom ersten Typ stromauf ihrer Einspeisepunkte in den Busmaster befinden, erfassen sie ihren eigenen Preselect-Strom nicht.

Jeder Adressier-Busslave vom zweiten Typ "will" durch seine Adressier-Stromquellen immer einen solchen Strom einspeisen, dass durch sein Strommessmittel ein für die Preselect-Phase vorgegebener Maximalstrom fließt. Dieser Maximalstrom ist typischerweise in der Preselect-Phase der gleiche wie in der Select-Phase; die jeweiligen Maximalströme beider Phasen können aber auch verschieden voneinander sein. Jeder Adressier-Busslave vom ersten Typ, der in der Preselect-Phase einen Strom misst, der kleiner als der Maximalstrom ist, nimmt an der sich anschließenden Select-Phase teil. Damit ist der Kreis derjenigen Adressier-Busslaves vom ersten Typ, aus denen der letzte identifiziert ist, um ihm dann eine Adresse zu geben, verkleinert.

Dadurch, dass ein Adressier-Busslave vom zweiten Typ bereits in der Preselect-Phase einen so großen Strom einspeist, dass der Maximalstrom erreicht ist, nehmen automatisch all die Adressier-Busslaves vom ersten Typ, die zwischen dem Busmaster und dem ersten stromauf des Busmaster angeordneten Adressier-Busslave vom zweiten Typ angeordnet sind, nicht an der Select-Phase teil, da sie nämlich sämtlich feststellen, dass durch den Bus bereits der Maximalstrom fließt.

In der Select-Phase erhöhen die teilnehmenden Adressier-Busslaves vom ersten Typ ihren Einspeisestrom. Nur dann, wenn sich ein Adressier-Busslave vom ersten Typ an der letzten Stelle befindet, stellt dieser Adressier-Busslave vom ersten Typ fest, dass sich in der Select-Phase der durch sein Strommessmittel fließende Strom gegenüber dem Offset-Abgleich nicht verändert hat. Damit steht fest, dass dieser Adressier-Busslave vom ersten Typ der letzte Adressier-Busslave ist, der sich dementsprechend dann die Adresse des gerade auf dem Bus liegenden Frame nimmt.

Ein Adressier-Busslave vom zweiten Typ merkt dadurch, dass seine Adressier-Stromquelle genau denjenigen Strom liefert, den er über sein Strommessmittel als "Gesamtstrom" misst, dass er der letzte Adressier-Busslave ist. Würde er nicht der letzte Adressier-Busslave vom zweiten Typ sein, d.h. würde hinter ihm noch mindestens ein weiterer Adressier-Busslave vom ersten Typ als letzter Adressier-Busslave sein, so würde sich ein gemessener Strom in der Select-Phase nicht gegenüber der Preselect-Phase verändern, er würde aber durch seine eigene Adressier-Stromquelle einen geringeren Strom einspeisen, als in der Preselect-Phase. Denn von dem letzten Adressier-Busslave (vom ersten Typ) fließt in der Select-Phase ein gegenüber der Preselect-Phase erhöhter Strom in dem Bus. Ein weiterer Adressier-Busslave vom zweiten Typ könnte übrigens hinter dem gerade betrachteten z.B. vorletzten Adressier-Busslave vom zweiten Typ nicht angeordnet sein, da dieser weitere Adressier-Busslave vom zweiten Typ in der Preselect-Phase einen so großen Adressierstrom eingespeist hätte, dass der vorletzte Adressier-Busslave vom zweiten Typ mit seinem Strommessmittel bereits den Maximalstrom detektiert hätte und somit in der nachfolgenden Select-Phase nicht mehr teilnimmt.

Würde sich also hinter dem vorletzten Adressier-Busslave vom zweiten Typ noch ein Adressier-Busslave vom ersten Typ als letzter Adressier-Busslave befinden, so würde der Adressier-Busslave vom zweiten Typ in der Select-Phase seinen Adressier-Strom reduzieren, da nämlich vom letzten Adressier-Busslave (vom ersten Typ) in der Select-Phase gegenüber der Preselect-Phase ein größerer Strom eingespeist würde, so dass der vorletzte Adressier-Busslave (vom zweiten Typ) seinen Adressier-Strom reduzieren würde, um den Maximalstrom, der durch sein Strommessmittel fließt, nicht zu überschreiten.

Ein Adressier-Busslave vom zweiten Typ wird also stets dadurch erkannt (d.h. erkennt sich selbst als letzten Adressier-Busslave dadurch), dass seine Adressierstromquelle denjenigen Strom in den Bus einspeist, den der Adressier-Busslave vom zweiten Typ mit seinem Strommessmittel misst. Dies gilt im Übrigen unabhängig davon, ob der für die Preselect-Phase vorgegebene Maximalstrom im Bus gleich dem oder verschieden ist von dem Maximalstrom, der für die Select-Phase vorgegeben ist.

### BEZUGSZEICHENLISTE

- 10: Datenbussystem
- 12: Busmaster
- 14: Busleitung
- 16: Strommessmittel
- 18: Strommessmittel
- 20: Busshunt
- 22: Busshunt
- 24: Busshunt
- 26: Adressierstromquelle
- 28: Adressierstromquelle
- 30: Preselect-Adressierstrom
- 32: Busstrom
- 34: Busstrom
- 36: Busstrom
- 38: Busstrom
- 40: Preselect-Adressierstrom
- 41: Preselect- bzw. Select-Adressierstrom
- 42: Select-Adressierstrom
- 44: Busstrom
- 46: Select-Adressierstrom
- 48: Busstrom
- 50: Select-Adressierstrom
- 52: Select-Adressierstrom
- 60: Adressier-Busslave
- 60': Adressier-Busslave
- 60": Adressier-Busslave
- 60"': Adressier-Busslave
- 62: Autoadressier-IC
- 62": Autoadressier-IC
- 64: Anschlussleitung
- 66: Anschlussleitung
- 68: EMV-Schutz- und Filterschaltung
- 70: Messverstärker

- BS1: Standard-Busslave
- BS2: Adressier-Busslave vom ersten Typ
- BS3: Adressier-Busslave vom zweiten Typ
- BS4: Adressier-Busslave vom zweiten Typ
- BS5: Adressier-Busslave vom ersten Typ
- BS6: Adressier-Busslave vom ersten Typ
- BS7: Adressier-Busslave vom ersten Typ
- BS8: Adressier-Busslave vom ersten Typ

## Patentansprüche

1. Verfahren zur Identifizierung von Busslaves in einem seriellen LIN-Datenbussystem für
die Vergabe von Adressen in dem seriellen Datenbussystem, das eine Busleitung, einen Busmaster und mehrere Busslaves aufweist, wobei einerseits der Busmaster an die Busleitung angeschlossen ist und andererseits die Busslaves vom Busmaster aus betrachtet aufeinanderfolgend mit der Busleitung verbunden sind,
- wobei einer der Busslaves der am nächsten zum Busmaster (12) an die Busleitung angeschlossene erste Busslave (BS1) ist und die anderen Busslaves, bezogen auf die Richtung eines in der Busleitung (14) zum Busmaster (12) fließenden Stroms, stromauf des ersten Busslaves (BS1) an die Busleitung (14) angeschlossen sind,
- wobei zumindest zwei der Busslaves als adressierbare Adressier-Busslaves (BS2 - BS8) ausgebildet sind, denen von dem Busmaster (12) in einer Adressierphase jeweils eine Adresse zugeordnet wird, und weitere der Busslaves als Standard-Busslaves (BS1) mit einer vor der Durchführung der Adressierphase bereits festgelegten Adresse versehen sein können,
- wobei sich unter den Adressier-Busslaves mindestens ein Adressier-Busslave (BS2, BS5 - BS8) eines ersten Typs und mindestens ein Adressier-Busslave (BS3, BS4) eines vom ersten Typ verschiedenen zweiten Typs befindet,
- wobei jedem Adressier-Busslave (BS2, BS5 - BS8) vom ersten Typ und jedem Adressier-Busslave (BS3, BS4) vom zweiten Typ ein elektrisch in die Busleitung (14) geschaltetes Strommessmittel (16,18) zugeordnet ist und jeder Adressier-Busslave (BS2, BS5 - BS8) vom ersten Typ und jeder Adressier-Busslave (BS3, BS4) vom zweiten Typ eine von dem jeweiligen Adressier-Busslave (BS2 - BS8) ansteuerbare Adressierstromquelle (26,28) aufweist,
- wobei der von der Adressierstromquelle (26) jedes Adressier-Busslaves (BS2, BS5 - BS8) vom ersten Typ in die Busleitung (14) eingespeiste Strom mit Ausnahme des dem jeweiligen Adressier-Busslave (BS2, BS5 - BS8) vom ersten Typ zugeordneten Strommessmittels (26) sämtliche stromab dieses Strommessmittels (26) in der Busleitung (14) befindliche Strommessmittel (26,28) durchfließt,
- wobei der von der Adressierstromquelle (28) jedes Adressier-Busslaves (BS3, BS4) vom zweiten Typ in die Busleitung (14) eingespeiste Strom sowohl das dem jeweiligen Adressier-Busslave (BS3, BS4) vom zweiten Typ zugeordnete Strommessmittel (28) als auch sämtliche stromab dieses Strommessmittels (28) in der Busleitung (14) befindliche Strommessmittel (26, 28) durchfließt,
- wobei zur Vergabe von Adressen an noch nicht adressierte Adressier-Busslaves (BS2 - BS8) vom ersten Typ und vom zweiten Typ mehrere Identifizierzyklen durchlaufen werden und pro Identifizierzyklus einer der noch nicht adressierten Adressier-Busslaves (BS2 - BS8) vom ersten Typ oder vom zweiten Typ identifiziert wird,
- wobei pro Identifizierzyklus
- in einem Offset-Abgleich
- jeder noch nicht adressierte Adressier-Busslave (BS2, BS5 - BS8) vom ersten Typ und jeder noch nicht adressierte Adressier-Busslave (BS3, BS4) vom zweiten Typ mittels des ihm jeweils zugeordneten Strommessmittels (28) einen potentiellen Ruhestrom misst,
- in einer ersten Preselect-Phase
- die Adressierstromquelle (26) jedes noch nicht adressierten Adressier-Busslaves (BS2, BS5 - BS8) vom ersten Typ in die Busleitung (14) einen Preselect-Einzelstrom einspeist,
- jeder noch nicht adressierte Adressier-Busslave (BS2, BS5 - BS8) vom ersten Typ mittels des ihm zugeordneten Strommessmittels (26) einen Busstrom misst, und
- die Adressierstromquellen (28) jedes noch nicht adressierten Adressier-Busslaves (BS3, BS4) vom zweiten Typ in die Busleitung (14) einen Preselect-Einzelstrom mit einer solchen Größe einspeisen, dass der Strom, der von dem dem jeweiligen Adressier-Busslave (BS3, BS4) vom zweiten Typ zugeordneten Strommessmittel (28) erfasst wird, gleich einem vorgebbaren Maximalstrom ist, und
- in einer sich an die erste Phase anschließenden zweiten Select-Phase
- die Adressierstromquellen (26) derjenigen Adressier-Busslaves (BS2, BS5 - BS8) vom ersten Typ, deren zugeordnete Strommessmittel (26) in der ersten Phase jeweils einen Busstrom erfassen, der kleiner ist als der Maximalstrom oder gleich dem Maximalstrom ist, einen gegenüber der ersten Phase erhöhten Adressierstrom einspeisen,
- die Adressierstromquellen (26) derjenigen Adressier-Busslaves (BS2, BS5 - BS8) vom ersten Typ, deren zugeordnete Strommessmittel (26) in der ersten Phase jeweils einen Busstrom erfassen, der größer ist als der Maximalstrom, keinen Adressierstrom einspeisen, und
- die Adressierstromquellen (28) der Adressier-Busslaves (BS3, BS4) vom zweiten Typ so gesteuert werden, dass der Busstrom, den das dem jeweiligen Adressier-Busslave (BS3, BS4) vom zweiten Typ zugeordnete Strommessmittel (28) erfasst, gleich dem Maximalstrom ist, und
- nach Ablauf der zweiten Phase unter den noch nicht adressierten Adressier-Busslaves (BS2 - BS8) vom ersten Typ und vom zweiten Typ derjenige Adressier-Busslave (BS2 - BS8) identifiziert wird, der am weitesten entfernt vom Busmaster (12) an die Busleitung (14) angeschlossene Adressier-Busslave (BS2 - BS8) ist, d.h. der in dem betreffenden Zyklus jeweils letzte Adressier-Busslave (BS2 - BS8) ist, indem
- ein Adressier-Busslave (BS2, BS5 - BS8) vom ersten Typ sich dadurch als letzter an die Busleitung angeschlossener Busslave identifiziert, dass das diesem Adressier-Busslave (BS2, BS5 - BS8) vom ersten Typ zugeordnete Strommessmittel (28) in der zweiten Phase keinen gegenüber dem Ruhestrom des Offset-Abgleichs erhöhten oder keinen gegenüber dem Ruhestrom des Offset-Abgleichs um mehr als einen vorgebbaren Schwellwert erhöhten Busstrom erfasst, und
- ein Adressier-Busslave (BS2, BS5 - BS8) vom zweitenTyp sich dadurch als letzter an die Busleitung angeschlossener Busslave identifiziert, dass dessen Adressierstromquelle (28) in der zweiten Phase einen Adressierstrom einspeist, der gleich dem Busstrom ist, den das diesem Adressier-Busslave (BS3, BS4) vom zweiten Typ zugeordnete Strommessmittel (18) in der ersten Phase misst, und
- einem in einem Identifizierzyklus identifizierten Adressier-Busslave (BS2-BS8) vom ersten Typ oder vom zweiten Typ vor Beginn des nächsten Identifizierzyklus vom Busmaster (12) eine Adresse zugewiesen wird.

2. Verfahren nach Anspruch 1, **dadurch gekennzeichnet, dass** die Strommessmittel (26, 28) der Adressier-Busslaves (BS2 - BS8) vom ersten Typ und vom zweiten Typ jeweils als ohmsche Widerstände realisiert sind, wobei der Wert des das Strommessmittel (26) eines Adressier-Busslaves (BS2, BS5 - BS8) vom ersten Typ repräsentierenden ohmschen Widerstands größer ist, und zwar insbesondere um mindestens das 2-Fache bis 20-Fache größer ist als der Wert des das Strommessmittel (28) eines Adressier-Busslaves (BS3, BS4) vom zweiten Typ repräsentierenden ohmschen Widerstands.

3. Verfahren nach Anspruch 2, **dadurch gekennzeichnet, dass** das Strommessmittel (26) eines Adressier-Busslaves (BS2, BS5 - BS8) vom ersten Typ als in einem IC (62) dieses Adressier-Busslaves (BS2, BS5 - BS8) vom ersten Typ integrierter Widerstand ausgebildet ist und dass das Strommessmittel (28) eines Adressier-Busslaves (BS3, BS4) vom zweiten Typ als Parallelschaltung aus einem in einem IC (60) dieses Adressier-Busslaves (BS3, BS4) vom zweiten Typ integrierten Widerstand und einem außerhalb des IC (60) angeordneten externen Widerstand ausgebildet ist, wobei die jeweils mit den integrierten Widerständen versehenen ICs (60) der Adressier-Busslaves (BS2, BS5 - BS8) vom ersten Typ und Adressier-Busslaves (BS2 - BS8) vom zweiten Typ gleich sind.

## Claims

1. A method for identifying bus slaves in a serial data bus system in order to allocate addresses in the serial data bus system, which has a bus line, a bus master, and multiple bus slaves, wherein the bus master is connected to the bus line on one side and the bus slaves are successively connected to the bus line on the other side when viewed from the bus master,
- wherein one of the bus slaves is the first bus slave (BS1), which is connected to the bus line closest to the bus master (12), and the other bus slaves are connected to the bus line (14) upstream of the first bus slave (BS1), with respect to the direction of a current flowing in the bus line (14) to the bus master (12),
- wherein at least two of the bus slaves are designed as addressable bus slaves to be addressed (BS2 - BS8), to which an address is respectively allocated by the bus master (12) in an addressing phase, and others of the bus slaves may be provided as standard bus slaves (BS1) with an address already determined prior to carrying out the addressing phase,
- wherein the bus slaves to be addressed include at least one bus slave to be addressed (BS2, BS5 - BS8) of a first type and at least one bus slave to be addressed (BS3, BS4) of a second type, different from the first type,
- wherein a current measuring means (16, 18), electrically switched in the bus line (14), is assigned to each bus slave to be addressed (BS2, BS5 - BS8) of the first type and to each bus slave to be addressed (BS3, BS4) of the second type, and each bus slave to be addressed (BS2, BS5 - BS8) of the first type and each bus slave to be addressed (BS3, BS4) of the second type has an addressing current source (26, 28) controllable by the respective bus slave to be addressed (BS2 - BS8),
- wherein the current, supplied into the bus line (14) by the addressing current source (26) of each bus slave to be addressed (BS2, BS5 - BS8) of the first type, flows through all current measuring means (26, 28) located in the bus line (14) downstream of this current measuring means (26), with the exception of the current measuring means (26) assigned to the respective bus slave to be addressed (BS2, BS5 - BS8) of the first type,
- wherein the current, supplied into the bus line (14) by the addressing current source (28) of each bus slave to be addressed (BS3, BS4) of the second type, flows through both the current measuring means (28) assigned to the respective bus slave to be addressed (BS3, BS4) of the second type and also all current measuring means (26, 28) located in the bus line (14) downstream of this current measuring means (28),
- wherein, to allocate addresses to bus slaves to be addressed (BS2 - BS8) of the first type and of the second type which are not yet addressed, a plurality of identification cycles is carried out, and one of the not yet addressed bus slaves to be addressed (BS2 - BS8) of the first type or of the second type is identified per identification cycle,
- wherein, per identification cycle
- in an offset adjustment:
- each of the not yet addressed bus slaves to be addressed (BS2, BS5 - BS8) of the first type and each of the not yet addressed bus slaves to be addressed (BS3, BS4) of the second type measures a potential idle current by means of the current measuring means (28) respectively assigned to it,
- in a first preselect phase:
- the addressing current source (26) of each not yet addressed bus slave to be addressed (BS2, BS5 - BS8) of the first type supplies a preselect single current into the bus line (14),
- each of the not yet addressed bus slaves to be addressed (BS2, BS5 - BS8) of the first type measures a bus current by means of the current measuring means (26) respectively assigned to it, and
- the addressing current source (28) of each not yet addressed bus slave to be addressed (BS3, BS4) of the second type supplies a preselect single current into the bus line (14) of a magnitude such that the current, which is detected by the current measuring means (28) assigned to the respective bus slave to be addressed (BS3, BS4) of the second type, is equal to a predefinable maximum current, and
- in a second select phase following the first phase:
- the addressing current sources (26) of those bus slaves to be addressed (BS2, BS5 - BS8) of the first type, whose assigned current measuring means (26) respectively detect a bus current in the first phase, which is smaller than the maximum current or equal to the maximum current, supply an addressing current that is increased with respect to the first phase, and
- the addressing current sources (26) of those bus slaves to be addressed (BS2, BS5 - BS8) of the first type, whose assigned current measuring means (26) respectively detect a bus current in the first phase which is greater than the maximum current, do not supply an addressing current,
- the addressing current sources (28) of the bus slaves to be addressed (BS3, BS4) of the second type are controlled so that the bus current, which the current measuring means (28) assigned to the respective bus slave to be addressed (BS3, BS4) of the second type detects, is equal to the maximum current, and
- at the end of the second phase, that bus slave to be addressed (BS2 - BS8) is identified among the not yet addressed bus slaves to be addressed (BS2 - BS8) of the first type and of the second type, which is the bus slave to be addressed (BS2 - BS8) connected to the bus line (14) farthest away from the bus master (12), i.e., is the respectively last bus slave to be addressed (BS2 - BS8), in the relevant cycle, in that
- a bus slave to be addressed (BS2, BS5 - BS8) of the first type is identified as the last bus slave connected to the bus line, in that the current measuring means (28) assigned to this bus slave to be addressed (BS2, BS5 - BS8) of the first type detects in the second phase a bus current, which is not increased with respect to the idle current of the offset adjustment or is not increased by more than a predeterminable threshold value with respect to the idle current of the offset adjustment, and
- a bus slave to be addressed (BS2, BS5 - BS8) of the second type is identified as the last bus slave connected to the bus line, in that its addressing current source (28) supplies an addressing current in the second phase which is equal to the bus current, which the current measuring means (18), assigned to this bus slave to be addressed (BS3, BS4) of the second type, measures in the first phase, and
- an address is allocated by the bus master (12) to a bus slave to be addressed (BS2 - BS8) of the first type or of the second type, identified in an identification cycle, before the beginning of the next identification cycle.

2. The method according to claim 1, **characterized in that** the current measuring means (26, 28) of the bus slaves to be addressed (BS2 - BS8) of the first type and of the second type are respectively implemented as ohmic resistors, wherein the value of the ohmic resistance representing the current measuring means (26) of a bus slave to be addressed (BS2, BS5 - BS8) of the first type is greater, in particular, at least 2 times to 20 times greater than the value of the ohmic resistance representing the current measuring means (28) of a bus slave to be addressed (BS3, BS4) of the second type.

3. The method according to claim 2, **characterized in that** the current measuring means (26) of a bus slave to be addressed (BS2, BS5 - BS8) of the first type is designed as a resistor integrated into an IC (62) of this bus slave to be addressed (BS2, BS5 - BS8) of the first type, and that the current measuring means (28) of a bus slave to be addressed (BS3, BS4) of the second type is designed as a parallel connection made from a resistor integrated into an IC (60) of this bus slave to be addressed (BS3, BS4) of the second type and an external resistor arranged outside of the IC (60), wherein the respective ICs (60), provided with integrated resistors, of the bus slaves to be addressed (BS2, BS5 - BS8) of the first type and of the bus slaves to be addressed (BS2 - BS8) of the second type, are identical.

## Revendications

1. Procédé pour l'identification d'esclaves de bus dans un système de bus de données LIN sériel pour l'attribution d'adresses dans le système de bus de données sériel qui présente une ligne de bus, un maître de bus et plusieurs esclaves de bus, dans lequel le maître de bus est d'une part raccordé à la ligne de bus et les esclaves de bus sont d'autre part successivement connectés à la ligne de bus, vus depuis le maître de bus,
- dans lequel l'un des esclaves de bus est le premier esclave de bus (BS1) raccordé à la ligne de bus le plus proche du maître de bus (12) et les autres esclaves de bus sont raccordés à la ligne de bus (14) en amont du premier esclave de bus (BS1) par rapport au sens d'un courant circulant dans la ligne de bus (14) vers le maître de bus (12),
- dans lequel au moins deux des esclaves de bus sont configurés comme des esclaves de bus d'adressage (BS2 - BS8) adressables auxquels respectivement une adresse est associée par le maître de bus (12) dans une phase d'adressage, et d'autres esclaves de bus parmi les esclaves de bus peuvent être pourvus, en tant qu'esclaves de bus standard (BS1), d'une adresse déjà fixée avant l'exécution de la phase d'adressage,
- dans lequel au moins un esclave de bus d'adressage (BS2, BS5 - BS8) d'un premier type et au moins un esclave de bus d'adressage (BS3, BS4) d'un second type différent du premier type se trouvent parmi les esclaves de bus d'adressage,
- dans lequel un moyen de mesure de courant (16, 18) monté électriquement dans la ligne de bus (14) est associé à chaque esclave de bus d'adressage (BS2, BS5 - BS8) du premier type et à chaque esclave de bus d'adressage (BS3, BS4) du second type et chaque esclave de bus d'adressage (BS2, BS5 - BS8) du premier type et chaque esclave de bus d'adressage (BS3, BS4) du second type présente une source de courant d'adressage (26, 28) pouvant être commandée par l'esclave de bus d'adressage (BS2 - BS8) respectif,
- dans lequel le courant injecté dans la ligne de bus (14) par la source de courant d'adressage (26) de chaque esclave de bus d'adressage (BS2, BS5 - BS8) du premier type traverse, à l'exception du moyen de mesure de courant (26) associé à l'esclave de bus d'adressage (BS2, BS5 - BS8) du premier type respectif, tous les moyens de mesure de courant (26, 28) se trouvant en aval de ce moyen de mesure de courant (26) dans la ligne de bus (14),
- dans lequel le courant injecté dans la ligne de bus (14) par la source de courant d'adressage (28) de chaque esclave de bus d'adressage (BS3, BS4) du second type traverse à la fois le moyen de mesure de courant (28) associé à l'esclave de bus d'adressage (BS3, BS4) du second type respectif et tous les moyens de mesure de courant (26, 28) se trouvant en aval de ce moyen de mesure de courant (28) dans la ligne de bus (14),
- dans lequel, pour l'attribution d'adresses à des esclaves de bus d'adressage (BS2 - BS8) du premier type et du second type non encore adressés, plusieurs cycles d'identification sont mis en oeuvre et, par cycle d'identification, l'un des esclaves de bus d'adressage (BS2 - BS8) du premier type ou du second type non encore adressés est identifié,
- dans lequel, par cycle d'identification,
- dans une synchronisation de décalage
- chaque esclave de bus d'adressage (BS2, BS5 - BS8) du premier type non encore adressé et chaque esclave de bus d'adressage (BS3, BS4) du second type non encore adressé mesure un courant de repos potentiel au moyen du moyen de mesure de courant (28) qui lui est respectivement associé,
- dans une première phase de présélection
- la source de courant d'adressage (26) de chaque esclave de bus d'adressage (BS2, BS5 - BS8) du premier type non encore adressé injecte un courant individuel de présélection dans la ligne de bus (14),
- chaque esclave de bus d'adressage (BS2, BS5 - BS8) du premier type non encore adressé mesure un courant de bus au moyen du moyen de mesure de courant (26) qui lui est associé, et
- les sources de courant d'adressage (28) de chaque esclave de bus d'adressage (BS3, BS4) du second type non encore adressé injectent dans la ligne de bus (14) un courant individuel de présélection d'une grandeur telle que le courant qui est détecté par le moyen de mesure de courant (28) associé à l'esclave de bus d'adressage (BS3, BS4) du second type respectif est égal à un courant maximal pouvant être prédéfini, et
- dans une seconde phase de sélection suivant la première phase
- les sources de courant d'adressage (26) de ces esclaves de bus d'adressage (BS2, BS5 - BS8) du premier type, dont les moyens de mesure de courant (26) associés détectent dans la première phase respectivement un courant de bus qui est inférieur au courant maximal ou égal au courant maximal, injectent un courant d'adressage augmenté par rapport à la première phase,
- les sources de courant d'adressage (26) de ces esclaves de bus d'adressage (BS2, BS5 - BS8) du premier type, dont les moyens de mesure de courant (26) associés détectent dans la première phase respectivement un courant de bus qui est supérieur au courant maximal, n'injectent pas de courant d'adressage, et
- les sources de courant d'adressage (28) des esclaves de bus d'adressage (BS3, BS4) du second type sont commandées de sorte que le courant de bus détecté par le moyen de mesure de courant (28) associé à l'esclave de bus d'adressage (BS3, BS4) du second type respectif est égal au courant maximum, et
- après l'écoulement de la seconde phase, on identifie parmi les esclaves de bus d'adressage (BS2 - BS8) du premier type et du second type non encore adressés l'esclave de bus d'adressage (BS2 - BS8) qui est raccordé à la ligne de bus (14) et qui est le plus éloigné du maître de bus (12), c'est-à-dire qui est respectivement le dernier esclave de bus d'adressage (BS2 - BS8) dans le cycle concerné, par le fait que
- un esclave de bus d'adressage (BS2, BS5 - BS8) du premier type s'identifie comme dernier esclave de bus raccordé à la ligne de bus par le fait que le moyen de mesure de courant (28) associé à cet esclave de bus d'adressage (BS2, BS5 - BS8) du premier type ne détecte pas, dans la seconde phase, un courant de bus augmenté par rapport au courant de repos de la synchronisation de décalage ou un courant de bus augmenté de plus d'une valeur seuil pouvant être prédéfinie par rapport au courant de repos de la synchronisation de décalage, et
- un esclave de bus d'adressage (BS2, BS5 - BS8) du second type s'identifie comme dernier esclave de bus raccordé à la ligne de bus par le fait que sa source de courant d'adressage (28) injecte dans la seconde phase un courant d'adressage qui est égal au courant de bus que le moyen de mesure de courant (18) associé à cet esclave de bus d'adressage (BS3, BS4) du second type mesure dans la première phase, et
- une adresse est attribuée par le maître de bus (12) à un esclave de bus d'adressage (BS2 - BS8) du premier type ou du second type identifié dans un cycle d'identification avant le début du cycle d'identification suivant.

2. Procédé selon la revendication 1, **caractérisé en ce que** les moyens de mesure de courant (26, 28) des esclaves de bus d'adressage (BS2 - BS8) du premier type et du second type sont respectivement réalisés sous forme de résistances ohmiques, dans lequel la valeur de la résistance ohmique représentant le moyen de mesure de courant (26) d'un esclave de bus d'adressage (BS2, BS5 - BS8) du premier type est supérieure, et en particulier au moins 2 à 20 fois supérieure, à la valeur de la résistance ohmique représentant le moyen de mesure de courant (28) d'un esclave de bus d'adressage (BS3, BS4) du second type.

3. Procédé selon la revendication 2, **caractérisé en ce que** le moyen de mesure de courant (26) d'un esclave de bus d'adressage (BS2, BS5 - BS8) du premier type est réalisé comme une résistance intégrée dans un CI (62) de cet esclave de bus d'adressage (BS2, BS5 - BS8) du premier type et **en ce que** le moyen de mesure de courant (28) d'un esclave de bus d'adressage (BS3, BS4) du second type est réalisé comme un montage en parallèle constitué d'une résistance intégrée dans un CI (60) de cet esclave de bus d'adressage (BS3, BS4) du second type et d'une résistance externe disposée à l'extérieur du CI (60), dans lequel les CI (60) des esclaves de bus d'adressage (BS2, BS5 - BS8) du premier type et des esclaves de bus d'adressage (BS2 - BS8) du second type, lesquels CI sont respectivement pourvus des résistances intégrées, sont identiques.
